# FASCICULE DE BREVET EUROPEEN

(11) **EP 0 742 592 B1**
(45) Date de publication et mention de la délivrance du brevet: **02.08.2000**
(21) Numéro de dépôt: 96410047.3
(22) Date de dépôt: 06.05.1996
(51) Int. Cl.: H01L 27/02

(54) **Composant de protection sensible de circuit d'interface de lignes d'abonnés**
Empfindliches Schutzbauelement für Schnittstellenschaltung von Teilnehmerleitungen
Sensitive protection component for interface circuit of subscriber lines

(30) Priorité: 12.05.1995 FR 9505878
(43) Date de publication de la demande: 13.11.1996
(73) Titulaire: STMicroelectronics S.A., 94250 Gentilly (FR)
(72) Inventeur: Bernier, Eric, 37390 Mettray (FR)
(74) Mandataire: de Beaumont, Michel

(56) Documents cités:
- EP-A- 0 289 431
- EP-A- 0 388 022
- EP-A- 0 550 198
- EP-A- 0 600 810

## Description

La présente invention concerne les dispositifs de protection des circuits d'interface de lignes d'abonnés (SLIC). Il existe des besoins de protection spécifiques pour les circuits d'interface de lignes d'abonnés qui sont connectés à des lignes téléphoniques susceptibles de recevoir des perturbations diverses qui, dans certains cas, peuvent être particulièrement importantes, par exemple par suite de coups de foudre ou de contacts entre une ligne téléphonique et une ligne du réseau électrique.

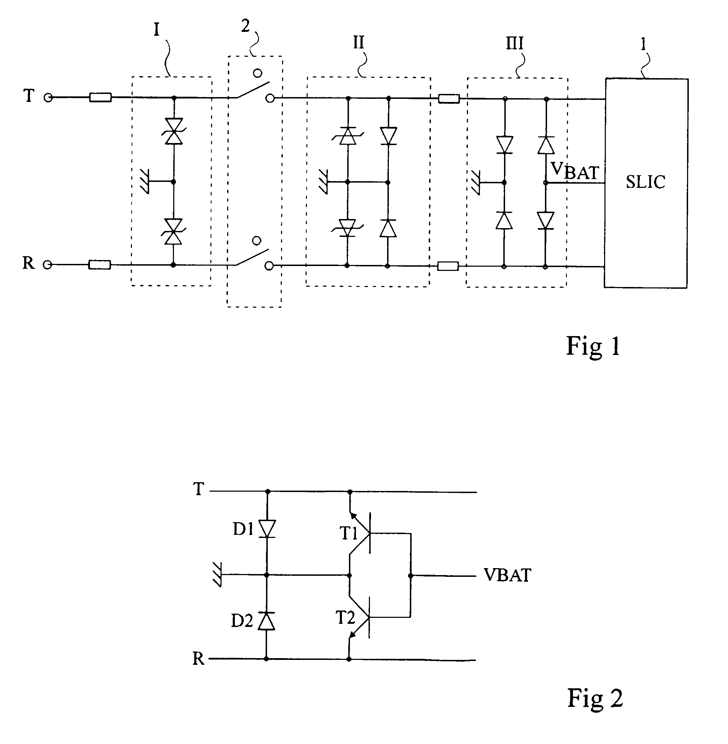

De façon générale, comme le représente la figure 1, les fils T et R d'une ligne téléphonique, habituellement polarisés à des tensions négatives (par exemple -50 et -4 volts, respectivement) sont reliés à l'entrée d'un circuit d'interface d'abonné par l'intermédiaire de relais de prise de ligne 2. Le circuit SLIC comprend divers circuits intégrés et est particulièrement sensible à l'apparition de surcharges électriques. Ainsi, dans la technique, on a développé de très nombreux modes de protection des circuits SLIC.

On utilise généralement séparément ou en combinaison des dispositifs de protection tels que ceux illustrés dans les blocs I, II et III de la figure 1.

Le dispositif de protection I est disposé en amont des relais de prise de ligne 2. Ce dispositif intervient quand les relais de prise de ligne sont en mode sonnerie et doit laisser passer des signaux de sonnerie relativement intenses. Pour cette raison, on trouve généralement dans ce dispositif des protections fixes de type bidirectionnel réglées à des valeurs de l'ordre de 250 volts avec une tenue en surcharge supérieure à 30 ampères pour une onde de surcharge normalisée 10/1000 microsecondes.

Le dispositif de protection II est disposé entre les relais de prise de ligne et le circuit SLIC et n'est susceptible d'intervenir qu'une fois que la ligne est prise, c'est-à-dire quand les relais sont en mode parole. Le niveau de protection est généralement réglé entre 50 et 80 volts. Ce composant doit aussi supporter de fortes surcharges telles que celles résultant d'un coup de foudre ou d'un contact avec une ligne électrique.

On a représenté dans les blocs I et II des exemples classiques de dispositifs de protection utilisés. On notera que ces dispositifs sont susceptibles de nombreuses variantes et modifications et qu'il a été proposé de regrouper les dispositifs des blocs I et II. De toute manière, ces dispositifs I et II, en raison du fait qu'ils doivent être capables d'absorber de très fortes surcharges ne peuvent pas, actuellement et à des coûts raisonnables, atteindre les caractéristiques de rapidité de réponse recherchées pour les circuits SLIC à circuits intégrés actuels.

En conséquence, on prévoit généralement un troisième niveau de protection rapprochée, le dispositif III de la figure 1, disposé au voisinage immédiat des entrées du circuit SLIC, qui doit être extrêmement rapide. Ceci est rendu possible du fait que ce dispositif n'est pas appelé à absorber des surcharges importantes mais seulement à absorber la partie initiale de montée rapide d'une surcharge. En effet, dès qu'un dispositif III entre en action, la résistance disposée en série avec la ligne avant ce dispositif III fait monter la tension de ligne et l'un des dispositifs I et II se déclenche. De façon générale, on estime que le dispositif III ne doit absorber que des intensités de l'ordre de quelques dizaines d'ampères pendant une durée inférieure à 20 microsecondes.

Un mode de réalisation d'un tel dispositif de protection rapprochée est illustré dans le bloc III de la figure 1. Il comprend simplement deux diodes dont les anodes sont connectées aux conducteurs de la ligne et dont les cathodes sont connectées ensemble à la masse et deux diodes dont les cathodes sont reliées aux conducteurs de la ligne et dont l'anode commune est reliée à la tension de batterie disponible à partir du circuit SLIC. Chacune de ces diodes est destinée à fonctionner en direct et l'on cherche à faire des diodes très rapides, à faible surtension à la mise en conduction (faible peak-on). Si une surtension positive apparaît sur l'une des lignes T et R (qui rappelons-le sont normalement polarisées négativement), elle sera éliminée par les diodes connectées à la masse. Si une surtension plus négative que la tension de batterie apparaît sur l'une des lignes, elle sera déchargée vers la tension de batterie V_{BAT} (habituellement une tension négative de l'ordre de -48 volts).

On ne connaît pas actuellement de dispositif équivalent au dispositif de protection rapprochée illustré dans le bloc III de la figure 1 et réalisé sous forme de composant monolithique sur un substrat semiconducteur unique. En effet, on voit que, dans ce circuit, il y a deux diodes connectées par leurs anodes et deux autres diodes connectées par leurs cathodes ce qui conduirait inévitablement à réaliser un circuit monolithique sous forme d'une combinaison de diodes verticales et de diodes latérales, ce qui nuirait à la rapididité du dispositif.

La présente invention vise à réaliser un tel composant sous forme de circuit monolithique sans nuire à ses caractéristiques de rapidité et de faible surtension à la mise en conduction.

Pour atteindre cet objet, la demanderesse a commencé par analyser divers dispositifs pouvant réaliser la fonction remplie par le dispositif de protection rapprochée III de la figure 1.

Parmi ces dispositifs, elle a sélectionné le dispositif qui sera décrit ci-après en relation avec la figure 2 puis a réalisé une intégration de ce dispositif.

Plus particulièrement, la présente invention prévoit un composant semiconducteur monolithique de protection à grande rapidité comprenant deux transistors NPN et deux diodes, les cathodes des diodes et les collecteurs des transistors étant reliés à une borne commune, l'anode d'une diode et l'émetteur d'un transistor étant reliés à une première borne, l'anode de l'autre diode et l'émetteur de l'autre transistor étant reliés à une deuxième borne, les bases des transistors étant reliées à une tension de référence. Ce composant comprend un substrat semiconducteur de type N faiblement dopé dont la face arrière comprend une couche fortement dopée revêtue d'une première métallisation, du côté de la face supérieure du substrat, des première et deuxième régions fortement dopées de type P, un caisson de type P faiblement dopé dans lequel sont formées des troisième et quatrième régions de type N et une cinquième région de type P, une deuxième métallisation reliant les première et troisième régions, une troisième métallisation reliant les deuxième et quatrième régions, et une quatrième métallisation solidaire de la cinquième région.

Selon un mode de réalisation de la présente invention, le caisson est entouré d'un anneau de type N.

Selon un mode de réalisation de la présente invention, la périphérie du composant est entourée d'un anneau de type N.

Selon un mode de réalisation de la présente invention, un anneau de type P est formé à la périphérie interne du caisson. Cet anneau peut être en continuité avec la cinquième région.

Selon un mode de réalisation de la présente invention, le substrat comprend une couche de type N faiblement dopée formée par épitaxie sur une plaquette de type N fortement dopée.

Selon un mode de réalisation de la présente invention, le caisson a une concentration superficielle de 1 à 5.10¹⁵ atomes/cm³, la profondeur de jonction étant de l'ordre de 30 à 40 micromètres.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
la figure 1 représente un schéma d'ensemble de protection d'un circuit d'interface de ligne d'abonné (SLIC) ;
la figure 2 représente sous forme de circuit un type particulier de dispositif de protection rapprochée d'un SLIC ;
les figures 3 et 4 représentent en coupe des modes de réalisation d'un composant semiconducteur monolithique selon la présente invention réalisant la fonction de protection rapprochée d'un SLIC ; et
la figure 5 représente un exemple de vue de dessus d'une structure double associant deux composants du type de la figure 3 ou 4.

Comme le représente la figure 2, la présente invention propose d'utiliser comme dispositif de protection rapprochée d'un circuit SLIC un dispositif comprenant deux diodes D1, D2 et deux transistors T1, T2. Les diodes sont connectées aux lignes T et R par leurs anodes respectives et sont connectées ensemble par leurs cathodes à la masse. Les transistors, de type NPN, sont reliés par leurs émetteurs respectifs aux lignes T et R. Les collecteurs des transistors sont interconnectés et reliés à la masse. Les bases des transistors sont interconnectées et reliées à la tension V_{BAT}.

Un avantage particulier de cette structure est que chacun des transistors se déclenche quand la tension sur son émetteur devient inférieure à la tension négative V_{BAT} mais qu'ensuite le courant de surcharge n'est pas extrait de la tension V_{BAT} mais de la masse. Ainsi, l'appel de courant sur la source de tension V_{BAT} correspondra à l'intensité de la surcharge divisée par le gain des transistors. Ceci est intéressant en pratique car, en fait, la tension V_{BAT} disponible à partir du circuit SLIC est une tension apparaissant aux bornes d'une capacité et que les normes actuelles exigent de minimiser les appels de courant.

Ainsi, la présente invention, après avoir sélectionné le circuit illustré en figure 2, vise à réaliser ce circuit sous forme de composant monolithique tout en gardant les avantages suivants :
- diodes D1 et D2 rapides et à faible peak-on,
- transistors T1 et T2 rapides à la commutation à la fermeture,
- transistors T1 et T2 de gain élevé (50 à 150), pour limiter le courant extrait de la source V_{BAT},
- transistors T1 et T2 à tenue en tension émetteur-base élevée (environ 100 V), pour supporter la tension normale appliquée en inverse,
- transistors T1 et T2 à faible résistance à l'état passant, pour éviter que le composant ne chauffe et ne puisse être détruit par une surtension.

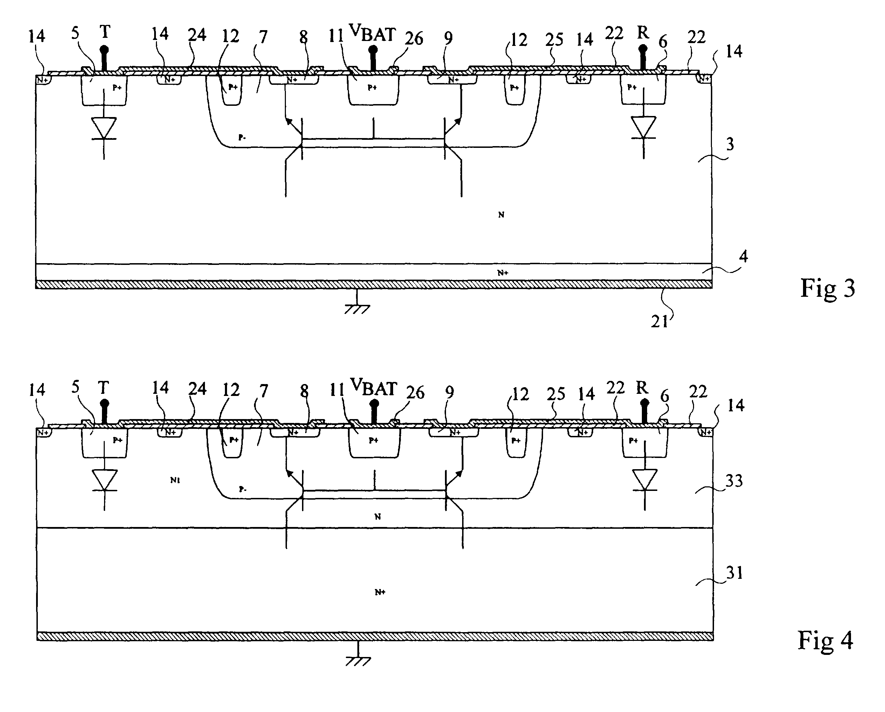

Un mode de réalisation du composant selon la présente invention est illustré dans la vue en coupe schématique de la figure 3. Conformément à l'usage dans le domaine de la représentation des composants semiconducteurs, les épaisseurs et dimensions des diverses couches et régions semiconductrices ne sont pas tracées à l'échelle.

Le composant est élaboré sur un substrat 3 de type N dont la face arrière comporte une couche de type N fortement dopée 4 (N⁺). Dans la face supérieure du substrat sont formées des première et deuxième régions 5 et 6 de type P relativement fortement dopées et un caisson 7 de type P plus faiblement dopé (P⁻). Dans le caisson 7, sont formées des régions N⁺ 8 et 9, une région P⁺ 11 et une région P⁺ périphérique 12. Des anneaux de type N⁺ 14 sont formés dans le substrat à la périphérie externe du caisson 7 et à la périphérie du composant.

La face inférieure du substrat est revêtue d'une métallisation 21. La surface supérieure du substrat est revêtue d'une couche mince d'oxyde 22 sauf aux emplacements où des contacts doivent être pris avec des métallisations. Sur la face supérieure, une première métallisation 24 est en contact avec la région 5 et la région 8, une deuxième métallisation 25 est en contact avec la région 6 et la région 9, et une troisième métallisation 26 est en contact avec la région 11.

Les métallisations 21, 24, 25 et 26 sont respectivement destinées à être connectées à la masse, au conducteur T, au conducteur R, et à la tension négative V_{BAT}. En effet, on trouve entre les métallisations 24 et 21 une diode D1 dont l'anode correspond à la région 5 et la cathode au substrat, et un transistor NPN T1 dont l'émetteur correspond à la région 8, la base au caisson 7 et le collecteur au substrat 3. De même, entre la métallisation 25 et la métallisation de face arrière 21 sont formés la diode D2 et le transistor T2. La métallisation 26 correspond à la base commune des transistors T1 et T2.

Dans ce composant, on choisit le substrat 3 pour que sa résistivité soit aussi faible que possible de façon à minimiser la surtension à la mise en conduction (peak-on) des diodes D1 et D2 constituées par les jonctions 5-3 et 6-3. Ceci permet de réaliser par diffusion (ou implantation/diffusion) un caisson P⁻ 7 faiblement dopé et donc d'assurer un gain élevé aux transistors NPN.

Le dopage du caisson 7 est par exemple choisi avec une concentration en surface Cₛ de 1 à 5.10¹⁵ atomes/cm³, la profondeur de jonction étant de l'ordre de 30 à 40 micromètres. On obtient alors une tenue en tension émetteur/base (B_{VBE}) de l'ordre de 80 à 150 V tout en ayant un gain élevé (de 50 à 150).

Les régions P⁺ 5, 6, 11 et 12 sont formées simultanément et auront par exemple une concentration en surface Cs de 1 à 5.1018 atomes/cm³, la profondeur de jonction étant de l'ordre de 20 à 25 micromètres. La concentration en surface étant choisie suffisamment élevée pour avoir un bon contact ohmique avec les métallisations. L'anneau périphérique 12 de type P⁺ a pour objet d'éviter des courants de fuite résultant de la création d'un canal d'inversion superficiel dont le risque d'apparition est élevé étant donné le très faible niveau de dopage du caisson 7. On minimise du même fait le risque de déclenchement éventuel de transistors ou thyristors parasites latéraux.

Les régions N⁺ 8, 9 et 14 et la couche de face arrière 4 sont formées simultanément et auront par exemple une concentration en surface Cₛ de 5.1020 à 3.1021 atomes/cm³, la profondeur de jonction étant de l'ordre de 7 à 15 micromètres. Les profondeurs de jonction sont ajustées essentiellement pour régler les gains des transistors. Les anneaux 14 ont une fonction d'arrêt de canal (stop-channel).

Le substrat 14 a par exemple une résistivité de 2 à 5 ohms.cm.

La présente invention est susceptible de diverses variantes et modifications qui apparaîtront à l'homme de l'art. En particulier, alors que l'on a décrit en figure 3 une structure obtenue à partir d'un substrat N dont la face arrière comprend une couche N⁺ formée par diffusion, on pourra utiliser comme matériau de départ un substrat de type N⁺ sur lequel une couche N est formée par épitaxie.

Une telle structure est représentée en coupe en figure 4 où le substrat N⁺ est désigné par la référence 31 et la couche épitaxiée par la référence 33. Ceci présente l'avantage de minimiser l'épaisseur de la couche 3 et donc d'améliorer le peak-on des diodes et la résistance à l'état passant (Ron) des transistors et aussi le gain de ces transistors. En effet, dans le cas d'une structure diffusée sur substrat N⁻ correspondant à la figure 3, pour une épaisseur de plaquette minimum (environ 200 micromètres), la couche 3 restante a une épaisseur de l'ordre de 150 micromètres tandis qu'avec une couche épitaxiée on peut choisir l'épaisseur de la couche 33 à une valeur minimum pour tenir la tension appliquée, soit environ 75 micromètres. Ce gain d'un facteur 2 sur l'épaisseur se retrouve sur l'amélioration du peak-on des diodes et de la résistance à l'état passant (Rₒₙ) des transistors.

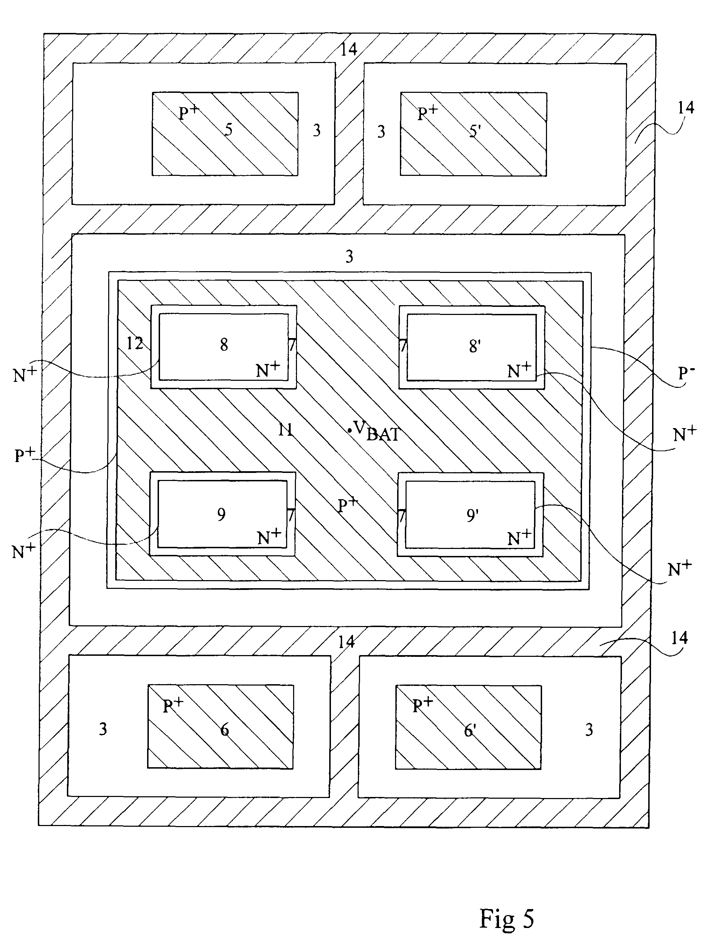

La figure 5 représente un exemple de vue de dessus (sans les métallisations) d'un composant associant deux structures telles que celles illustrées sous forme de vues en coupe fonctionnelles en figures 3 et 4. Ce composant peut être utilisé pour la protection de deux lignes arrivant sur un SLIC. Un premier ensemble de protection correspond à la partie droite de la figure et un deuxième à la partie gauche. Ces deux ensembles ont en commun la région de base 7 connectée à V_{BAT}. Les anneaux 14 sont continus.

## Revendications

1. Composant semiconducteur monolithique de protection à grande rapidité comprenant deux transistors NPN (T1, T2) et deux diodes (D1, D2), les cathodes des diodes et les collecteurs des transistors étant reliés à une borne commune, l'anode d'une diode et l'émetteur d'un transistor étant reliés à une première borne, l'anode de l'autre diode et l'émetteur de l'autre transistor étant reliés à une deuxième borne, les bases des transistors étant reliées à une tension de référence, comprenant :
- un substrat semiconducteur (3) de type N faiblement dopé dont la face arrière comprend une couche (4) fortement dopée revêtue d'une première métallisation (21),
- du côté de la face supérieure du substrat, des première et deuxième régions (5 et 6) fortement dopées de type P,
- un caisson (7) de type P faiblement dopé dans lequel sont formées des troisième et quatrième régions (8 et 9) de type N et une cinquième région (11) de type P,
- une deuxième métallisation (24) reliant les première et troisième régions,
- une troisième métallisation (25) reliant les deuxième et quatrième régions, et
- une quatrième métallisation (26) solidaire de la cinquième région (11).

2. Composant selon la revendication 1, caractérisé en ce que ledit caisson est entouré d'un anneau (14) de type N.

3. Composant selon la revendication 2, caractérisé en ce que sa périphérie est entourée d'un anneau (14) de type N.

4. Composant selon la revendication 1, caractérisé en ce qu'il comprend un anneau (12) de type P à la périphérie interne dudit caisson.

5. Composant selon la revendication 4, caractérisé en ce que ledit anneau (12) est en continuité avec la cinquième région (11).

6. Composant selon la revendication 1, caractérisé en ce que ledit substrat comprend une couche de type N faiblement dopée (33) formée par épitaxie sur une plaquette de type N (31) fortement dopée.

7. Composant selon la revendication 1, caractérisé en ce que ledit caisson (7) a une concentration superficielle de 1·10¹⁵ m⁻³ à 5·10¹⁵ cm⁻³, la profondeur de jonction étant de l'ordre de 30 à 40 micromètres.

## Patentansprüche

1. Monolithisches Halbleiter-Schutzbauteil hoher Geschwindigkeit, mit zwei NPN-Transistoren (T1, T2) und zwei Dioden (D1, D2), wobei die Kathoden der Dioden und die Kollektoren der Transistoren mit einem gemeinsamen Anschluß verbunden sind, die Anode einer Diode und der Emitter eines Transistors mit einem ersten Anschluß und die Anode der anderen Diode und der Emitter des anderen Transistors mit einem zweiten Anschluß verbunden sind, und die Basisanschlüsse der Transistoren mit einer Bezugsspannung verbunden sind, und wobei das Bauteil umfaßt:
- ein schwach dotiertes N-Halbleitersubstrat (3), dessen Rück- bzw. Unterseite eine mit einer ersten Metallisierung (21) überzogene stark dotierte Schicht (4) aufweist,
- an der Oberseite des Substrats stark dotierte erste und zweite P-Bereiche (5, 6),
- einen schwach dotierten P-Graben (7), in welchem dritte und vierte N-Bereiche (8, 9) und ein fünfter P-Bereich ausgebildet sind,
- eine den ersten und den dritten Bereich verbindende zweite Metallisierung (24),
- eine den zweiten und den vierten Bereich verbindende dritte Metallisierung (25), sowie
- eine mit dem fünften Bereich (11) einstückige vierte Metallisierung (26).

2. Bauteil nach Anspruch 1, dadurch gekennzeichnet, daß der genannte Graben von einem N-Ring (14) umschlossen ist.

3. Bauteil nach Anspruch 2, dadurch gekennzeichnet, daß es an seinem Umfang von einem N-Ring (14) umschlossen ist.

4. Bauteil nach Anspruch 1, dadurch gekennzeichnet, daß es einen P-Ring (12) am Innenumfang des genannten Grabens aufweist.

5. Bauteil nach Anspruch 4, dadurch gekennzeichnet, daß der genannte Ring (12) mit dem fünften Bereich (11) zusammenhängend ausgebildet ist.

6. Bauteil nach Anspruch 1, dadurch gekennzeichnet, daß das genannte Substrat eine durch Epitaxie auf einem stark dotierten N-Plättchen (31) gebildete schwach dotierte N-Schicht (33) aufweist.

7. Bauteil nach Anspruch 1, dadurch gekennzeichnet, daß der genannte Graben (7) an der Oberfläche eine Dotierungskonzentration im Bereich von 1 . 10¹⁵ cm⁻³ bis 5 . 10¹⁵ cm ⁻³ aufweist und die Tiefe des PN-Übergangs einen Wert in der Größenordnung von 30 bis 40 Mikrometer besitzt.

## Claims

1. A high-speed monolithic protection semiconductor component including two NPN transistors (T1, T2) and two diodes (Dl, D2), the cathodes of the diodes and the collectors of the transistors being connected to a common terminal, the anode of a diode and the emitter of a transistor being connected to a first terminal, the anode of the other diode and the emitter of the other transistor being connected to a second terminal, the bases of the transistors being connected to a reference voltage, including:
- a low-doped N-type semiconductor substrate (3) whose bottom surface includes a highly-doped layer (4) coated with a first metallization (21),
- on the side of the upper surface of the substrate, first and second highly-doped P-type regions (5, 6),
- a low-doped P-type well (7) in which are formed N-type third and fourth regions (8, 9) and a P-type fifth region (11),
- a second metallization (24) connecting said first and third regions,
- a third metallization (25) connecting said second and fourth regions, and
- a fourth metallization (26) integral with said fifth region (11).

2. The component of claim 1, characterized in that said well is surrounded with an N-type ring (14).

3. The component of claim 2, characterized in that its periphery is surrounded with an N-type ring (14).

4. The component of claim 1, characterized in that it includes a P-type ring (12) formed at the inner periphery of said well.

5. The component of claim 4, characterized in that said ring (12) is continuous with said fifth region (11).

6. The component of claim 1, characterized in that said substrate includes a low-doped N-type layer (33) epitaxially formed on a highly-doped N-type wafer (31).

7. The component of claim 1, characterized in that said well (7) has a surface concentration ranging from 1.10¹⁵ cm⁻³ to 5.10¹⁵ cm⁻³, the junction depth ranging from 30 to 40 µm.
